# EUROPÄISCHE PATENTSCHRIFT

(11) **EP 0 309 769 B1**
(45) Veröffentlichungstag und Bekanntmachung des Hinweises auf die Patenterteilung: **17.03.1993**
(21) Anmeldenummer: 88114401.8
(22) Anmeldetag: 03.09.1988
(51) Int. Cl.: H03B 5/36

(54) **Spannungsgesteuerter Oszillator mit einem keramischen Schwingquarz**
Voltage-controlled oscillator comprising a ceramic crystal
Oscillateur commandé en tension à cristal céramique

(30) Priorität: 30.09.1987 DE 3732906
(43) Veröffentlichungstag der Anmeldung: 05.04.1989
(73) Patentinhaber: Deutsche Thomson-Brandt GmbH, 78003 Villingen-Schwenningen (DE)
(72) Erfinder: Berger, Philippe, D-7730 Villingen-Schwenningen (DE); Douziech, Patrick, D-7730 Villingen-Schwenningen (DE); Berland, Pierre Axel, D-7730 Villingen-Schwenningen (DE)

(56) Entgegenhaltungen:
- DE-A- 2 131 159
- FR-A- 2 506 100
- GB-A- 2 053 608
- PATENT ABSTRACTS OF JAPAN, Band 8, Nr. 64 (E-234)[1503], 28. März 1984; & JP-A-58 215 809 (MITSUBISHI DENKI K.K.) 15-12-83

## Beschreibung

Die Erfindung betrifft einen spannungsgesteuerten Oszillator mit einem keramischen Schwingquarz.

Es sind Fernsehgeräte mit einem Teletextdecoder bekannt, bei denen einige Seiten Teletext speicherbar sind und auf dem Bildschirm angezeigt werden können. Um ein Flimmern des Bildes mit Sicherheit zu vermeiden, ist ein sehr genauer spannungsgesteuerter Oszillator nötig. Meist wird ein spannungsgesteuerter Oszillator mit einem keramischen Schwingquarz verwendet.

Aus der GB-A 2 053 608 ist eine Quarzoszillatorschaltung mit Phasenschiebern im Rückkopplungskreis bekannt, bei denen die Phasenlage durch Addition zweier Signale unterschiedlicher Phasenlage, deren Verhältnis zueinander verändert werden kann, bestimmt wird.

Bei dieser Oszillatorschaltung ist der Ausgang des Oszillators mit dem Eingang eines ersten Phasenschiebers verbunden. Der Ausgang des ersten Phasenschiebers ist über einen ersten Rückkopplungszweig, in dem ein zweiter Phasenschieber und ein Verstärker liegen, mit dem ersten Eingang einer Summationsschaltung verbunden. Der Ausgang des ersten Phasenschiebers ist außerdem über einen zweiten Rückkopplungszweig, in dem ein Multiplizierer liegt, mit dem zweiten Eingang der Summationsschaltung verbunden, deren Ausgang mit dem Eingang des Oszillators verbunden ist.

In der DE-OS 21 31 159 ist ebenfalls eine Oszillatorschaltung mit Phasenschiebern im Rückkopplungskreis beschrieben, bei denen die Phasenlage durch Addition zweier Signale unterschiedlicher Phasenlage, deren Verhältnis zueinander verändert werden kann, bestimmt wird.

In dieser Oszillatorschaltung ist der Ausgang des Oszillators mit dem Eingang eines Verstärkers verbunden. Der Ausgang des Verstärkers ist über eine Parallelschaltung aus einem ersten Phasenschieber zur Phasenvorauseilung und einem zweiten Phasenschieber zur Phasenverzögerung mit einer Summationsschaltung verbunden, deren Ausgang auf der Oszillator rückgekoppelt ist.

Integrierte Schaltkreise, in denen spannungsgesteuerte Oszillatoren integriert sind, weisen mehrere Anschlüsse, sogenannte Pins, auf. Beim Entwurf eines integrierten Schaltkreises trachtet der Entwickler stets danach, die Schaltkreise so zu entwerfen, daß möglichst wenige Pins erforderlich sind.

Es ist daher Aufgabe der Erfindung, einen spannungsgesteuerten Oszillator mit einem keramischen Schwingquarz so zu gestalten, daß er mit nur einem Pin zum Anschluß des keramischen Schwingquarzes auskommt, und trotzdem seine Frequenz mittels einer Spannung steuerbar ist.

Die Erfindung löst diese Aufgabe dadurch, daß die Ausgangsspannung des keramischen Schwingquarzes dem Eingang eines Phasenschiebers mit zwei parallel geschalteten Zweigen zugeführt wird, daß in einem Zweig ein Verstärker liegt, daß im anderen Zweig ein Tiefpaß, ein regelbarer Verstärker und ein steuerbarer Umschalter liegen, dessen erster Eingang mit dem Ausgang des regelbaren Verstärkers verbunden ist, dessen zweiter Eingang auf Bezugspotential liegt und dessen Ausgang mit dem ersten Eingang eines Summierers verbunden ist, daß der Ausgang des Verstärkers mit dem zweiten Eingang des Summierers verbunden ist und daß der Ausgang des Summierers auf den keramischen Schwingquarz rückgekoppelt ist.

Anhand des in der Figur gezeigten Ausführungsbeispieles wird die Erfindung zuerst beschrieben und anschließend erläutert.

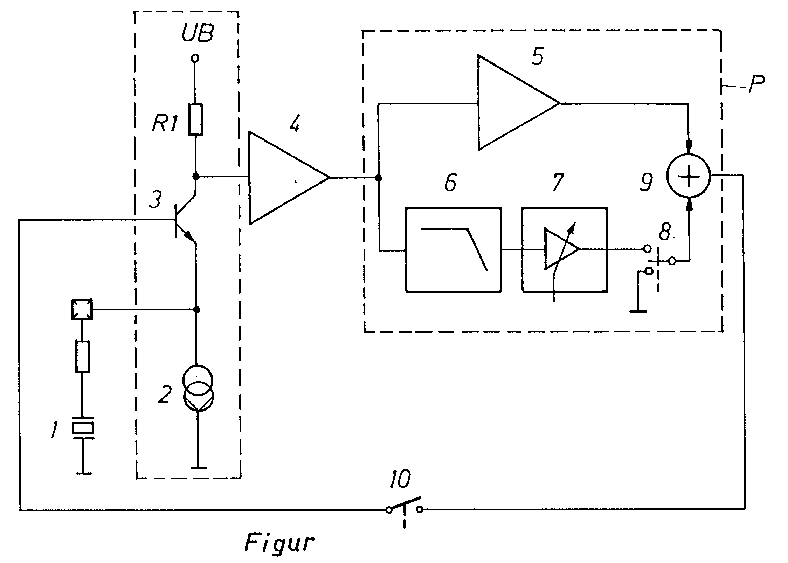

In der Figur 1 liegt der eine Anschluß einer Parallelschaltung aus einem keramischen Schwingquarz 1 und einer Stromquelle 2 auf Bezugspotential, während der andere Anschluß mit dem Emitter eines Transistors 3 verbunden ist. Der Kollektor des Transistors 3 ist mit dem Eingang eines Verstärkers 4 verbunden und liegt über einen Widerstand 3 an einer Versorgungsspannung UB. Der Ausgang des Verstärkers 4 ist mit dem Eingang eines Verstärkers 5 und eines Tiefpasses 6 verbunden, dessen Ausgang mit dem Eingang eines regelbaren Verstärkers 7 verbunden ist. Der Ausgang des regelbaren Verstärkers 7 ist mit dem ersten Eingang eines steuerbaren Umschalters 8 verbunden, dessen zweiter Eingang auf Bezugspotential liegt. Der Ausgang des steuerbaren Umschalters 8 ist mit dem ersten Eingang eines Summierers 9 verbunden, dessen zweiter Eingang mit dem Ausgang des Verstärkers 5 verbunden ist. Der Ausgang des Summierers 9 ist über einen steuerbaren Schalter 10 auf die Basis des Transistors 3 rückkoppelbar.

Der Verstärker 5 liegt im einen Zweig, der Tiefpaß 6, der regelbare Verstärker 7 und der steuerbare Umschalter 8 liegen im anderen Zweig des Phasenschiebers P. Wenn die Phasenverschiebung zwischen dem Signal am ersten und am zweiten Eingang des Summierers 9 null beträgt, so schwingt der keramische Schwingquarz mit seiner Resonanzfrequenz. Dieser Fall wird realisiert, indem die Verstärkung des Regelverstärkers 7 auf null gestellt wird. Genauer und einfacher läßt sich dieser Zustand aber dadurch erzielen, daß der steuerbare Umschalter 8 auf seinen zweiten Eingang umgeschaltet wird, so daß der erste Eingang des Summierers 9 auf Bezugspotential liegt. Soll nun der spannungsgesteuerte Oszillator seine Frequenz ändern, so ist der steuerbare Schalter 8 umzuschalten, so daß sein erster Eingang mit dem Ausgang verbunden ist. Wird nun die Verstärkung des regelbaren Verstärkers 7 positiv gewählt, so ergibt sich eine Phasenverschiebung, die größer als null ist. Bei einer Phasenverschiebung, die größer als null ist, wird beispielsweise die Frequenz des keramischen Schwingquarzes erhöht, während sie bei einer Phasenverschiebung die kleiner als null ist, erniedrigt wird. Eine Verringerung der Frequenz des keramischen Schwingquarzes wird deshalb dadurch erzielt, daß die Verstärkung des regelbaren Verstärkers 7 negativ gewählt wird.

Durch Verändern der Spannung am Regeleingang des regelbaren Verstärkers 7 wird bei dem in der Figur gezeigten Ausführungsbeispiel die Frequenz des keramischen Schwingquarzes 1 und damit des spannungsgesteuerten Oszillators verändert. Durch Umschalten des steuerbaren Umschalters 8 kann der spannungsgesteuerte Oszillator sofort und genau auf die Resonanzfrequenz des keramischen Schwingquarzes eingestellt werden.

## Patentansprüche

1. Spannungsgesteuerter Oszillator mit einem keramischen Schwingquarz (1), **dadurch gekennzeichnet**, daß die Ausgangsspannung des keramischen Schwingquarzes (1) dem Eingang eines Phasenschiebers (P) mit zwei parallel geschalteten Zweigen zugeführt wird, daß im einen Zweig ein Verstärker (5) liegt, daß im anderen Zweig ein Tiefpaß (6), ein regelbarer Verstärker (7) und ein steuerbarer Umschalter (8) liegen, dessen erster Eingang mit dem Ausgang des regelbaren Verstärkers (7) verbunden ist, dessen zweiter Eingang auf Bezugspotential liegt und dessen Ausgang mit dem ersten Eingang eines Summierers (9) verbunden ist, daß der Ausgang des Verstärkers (5) mit dem zweiten Eingang des Summierers (9) verbunden ist und daß der Ausgang des Summierers (9) auf den keramischen Schwingquarz (1) rückgekoppelt ist.

2. Spannungsgesteuerter Oszillator nach Anspruch 1, **dadurch gekennzeichnet**, daß der eine Anschluß einer Parallelschaltung aus dem keramischen Schwingquarz (1) und einer Stromquelle (2) auf Bezugspotential liegt, während ihre anderer Anschluß mit dem Emitter eines Transistors (3) verbunden ist, daß der Kollektor des Transistors (3) mit dem Eingang eines ersten Verstärkers (4) verbunden ist und über einen Widerstand (R1) an einer Versorgungsspannung (UB) liegt, daß der Ausgang des ersten Verstärkers (4) mit dem Eingang eines zweiten Verstärkers (5) und eines Tiefpasses (6) verbunden ist, daß der Ausgang des Tiefpasses (6) mit dem Eingang eines regelbaren Verstärkers (7) verbunden ist, dessen Ausgang mit dem ersten Eingang eines steuerbaren Umschalters (8) verbunden ist, daß der zweite Eingang des steuerbaren Umschalters (8) auf Bezugspotential liegt, daß der Ausgang des steuerbaren Umschalters (8) mit dem ersten Eingang eines Summierers (9) verbunden ist, dessen zweiter Eingang mit dem Ausgang des zweiten Verstärkers (5) verbunden ist und dessen Ausgang über einen steuerbaren Schalter (10) mit der Basis des Transistors (3) verbunden ist.

## Claims

1. Voltage controlled oscillator with a ceramic crystal (1) characterized in that the output voltage of the ceramic crystal (1) is fed to the input of a phase shifter (P) with two branches connected in parallel, that in one branch is an amplifier (5); that in the other branch are a low-pass filter (6), an adjustable amplifier (7) and a controllable changeover switch (8) whose first input is connected to the output of the adjustable amplifier (7), whose second input is connected to reference potential and whose output is connected to the first input of an adder (9); that the output of the amplifier (5) is connected to the second input of the adder (9); and that the output of the adder (9) is fed back to the ceramic crystal (1).

2. Voltage controlled oscillator according to claim 1 characterized in that the one terminal of a parallel connection of the ceramic crystal (1) and a power source (2) is connected to reference potential, whilst its other terminal is connected to the emitter of a transistor (3); that the collector of the transistor (3) is connected to the input of a first amplifier (4) and via a resistor (R1) is connected to a supply voltage (UB); that the output of the first amplifier (4) is connected to the input of a second amplifier (5) and a low-pass filter (6); that the output of the low-pass filter (6) is connected to the input of an adjustable amplifier (7) whose output is connected to the first input of a controllable changeover switch (8); that the second input of the controllable changeover switch (8) is connected to reference potential; and that the output of the controllable changeover switch (8) is connected to the first input of an adder (9), whose second input is connected to the output of the second amplifier (5) and whose output is connected via a controllable switch (10) to the base of the transistor (3).

## Revendications

1. Oscillateur commandé en tension à cristal céramique (1), **caractérisé en ce** que la tension de sortie du cristal céramique (1) est amenée à l'entrée d'un décaleur de phase (P) à deux branches montées en parallèle, qu'il y a un amplificateur (5) dans une branche, qu'il y a un passe-bas (6), un amplificateur réglable (7) et un commutateur (8) qui peut être commandé dans l'autre branche, commutateur dont la première entrée est reliée à la sortie de l'amplificateur réglable (7) dont la seconde entrée se trouve sur le potentiel de référence et dont la sortie est reliée à la première entrée d'un addeur (9), que la sortie de l'amplificateur (5) est reliée à la seconde entrée de l'addeur (9) et que la sortie de l'addeur (9) est réappliquée au cristal céramique (1).

2. Oscillateur commandé en tension selon la revendication 1, **caractérisé en ce** que l'un des raccords d'un montage parallèle constitué par le cristal céramique (1) et une source de courant (2) se trouve sur le potentiel de référence, tandis que son autre raccord est relié à l'émetteur d'un transistor (3), que le collecteur du transistor (3) est relié à l'entrée d'un premier amplificateur (4) et se trouve, par l'intermédiaire d'une résistance (R1), sur une tension d'alimentation (UB), que la sortie du premier amplificateur (4) est reliée à l'entrée d'un second amplificateur (5) et d'un passe-bas (6), que la sortie du passe-bas (6) est reliée à l'entrée d'un amplificateur réglable (7) dont la sortie est reliée à la première entrée d'un commutateur qui peut être commandé (8), que la seconde entrée du commutateur qui peut être commandé (8) se trouve sur le potentiel de référence, que la sortie du commutateur qui peut être commandé (8) est reliée à la première entrée d'un addeur (9), dont la seconde entrée est reliée à la sortie du second amplificateur (5) et dont la sortie est reliée par un commutateur qui peut être commandé (10) à la base du transistor (3).
